# EUROPEAN PATENT APPLICATION

(11) **EP 4 723 372 A1**
(43) Date of publication of application: **08.04.2026**
(21) Application number: 24836199.0
(22) Date of filing: 28.05.2024
(51) Int. Cl.: H01Q 1/24, H04M 1/02, F16B 43/00, H05K 1/18, H05K 1/02, H01Q 1/38

(54) **ANTENNA FEEDING STRUCTURE AND ELECTRONIC DEVICE INCLUDING SAME**

(30) Priority: 04.07.2023 KR 20230086811; 26.09.2023 KR 20230129212
(71) Applicant: Samsung Electronics Co., Ltd., Suwon-si, Gyeonggi-do 16677 (KR)
(72) Inventor: KANG, Hyeonuk, Suwon-si Gyeonggi-do 16677 (KR); KIM, Yongyoun, Suwon-si Gyeonggi-do 16677 (KR); KANG, Euisung, Suwon-si Gyeonggi-do 16677 (KR); KIM, Byungjoon, Suwon-si Gyeonggi-do 16677 (KR); KIM, Sungsoo, Suwon-si Gyeonggi-do 16677 (KR)
(74) Representative: Gulde & Partner
(86) International application number: PCT/KR2024/007215
(87) International publication number: WO 2025/009750

(57) **Abstract**

The present disclosure relates to an antenna feeding structure including a printed circuit board, and an electronic device including the antenna feeding structure. To this end, the electronic device may comprise: a metal member configured to radiate antenna signals; a printed circuit board having an electronic component configured to generate antenna signals mounted thereon; a metal sheet arranged such that a first surface thereof faces the printed circuit board and a second surface thereof, opposite to the first surface, faces the metal member; and a screw provided to fasten the printed circuit board, the metal sheet, and the metal member by sequentially penetrating therethrough. Various other embodiments are possible.

## Description

### [Technical Field]

Various embodiments of the disclosure relates to an antenna feeding structure including a printed circuit board and an electronic device including the same.

### [Background Art]

In response to the recent trend of thinner electronic devices and the widespread adoption of ultra-high-speed, large-capacity wireless communication, various functions may be incorporated into a single electronic device to offer integrated services.

To provide a communication device in a portable electronic device such as a mobile communication terminal or a tablet PC, the frame of the exterior of the electronic device may be implemented with a metal material. Accordingly, the metal frame may be utilized as a radiator of an antenna, and may have the advantage of implementing multi-band antennas.

To increase the integration of electronic devices while providing high-performance antenna performance, there is a need to efficiently arrange electrical components mounted inside the electronic device.

### [Disclosure of Invention]

### [Technical Problems]

Various embodiments of the disclosure may provide an electronic device in which an antenna feeding structure is fastened to be inclined at a predetermined angle to an outer frame formed of metal material.

### [Solution to Problems]

An electronic device according to an embodiment of the disclosure may include: a frame, a metal member provided inside the frame, a metal sheet disposed such that a first surface faces a printed circuit board and a second surface opposite to the first surface faces the metal member, and a screw configured to penetrate and fasten the printed circuit board, the metal sheet, and the metal member sequentially. The metal sheet may have the first surface inclined at a specified angle relative to the second surface.

An antenna feeding structure according to an embodiment of the disclosure may include: a metal member, a metal sheet disposed such that one surface faces the metal member, and a screw configured to penetrate and fasten the metal sheet and the metal member sequentially. The one surface of the metal sheet may have an inclination at a specified angle relative to another surface facing a printed circuit board.

### [Advantageous Effects]

An electronic device according to an embodiment of the disclosure may provide efficient arrangement of electrical components mounted internally.

An electronic device according to an embodiment of the disclosure may provide ease of fastening of an antenna feeding structure.

An electronic device according to an embodiment of the disclosure may provide enhanced antenna performance through arrangement of an antenna feeding structure.

### [Brief Description of Drawings]

FIG. 1 is a block diagram illustrating an electronic device in a network environment according to various embodiments of the disclosure.
FIG. 2 is a front perspective view illustrating an electronic device according to various embodiments of the disclosure.
FIG. 3 is a rear perspective view illustrating an electronic device according to various embodiments of the disclosure.
FIG. 4 is an exploded perspective view illustrating an electronic device according to various embodiments of the disclosure.
FIG. 5 is a diagram illustrating a plan view of a circuit board assembly connected to a side frame of an electronic device, according to an embodiment of the disclosure.
FIG. 6 is a perspective view illustrating a circuit board assembly connected to a side frame of an electronic device, according to an embodiment of the disclosure.
FIG. 7 is a cross-sectional view illustrating an electronic device, according to an embodiment of the disclosure.
FIG. 8 is a front view illustrating a circuit board assembly in an unfolded state, according to an embodiment of the disclosure.
FIG. 9 is a cross-sectional view in an exploded state of an antenna feeding structure, according to an embodiment of the disclosure.
FIG. 10 is a cross-sectional view illustrating an electronic device, according to an embodiment of the disclosure.

In connection with the description of the drawings, the same or similar reference numerals may be used to denote the same or similar elements.

### [Mode for the Invention]

Hereinafter, embodiments of the disclosure are described in greater detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description may be made of well-known functions and configurations in the drawings and relevant descriptions.

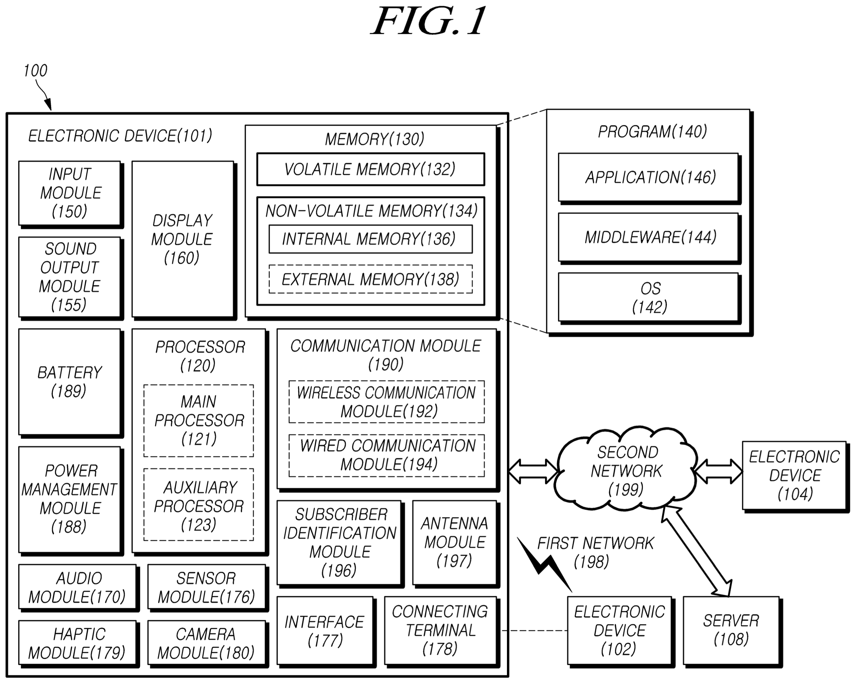

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network).According to an embodiment, the electronic device 101 may communicate with the electronic device 104 via the server 108.According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197.In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software(e.g., the program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134.According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, in case that the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application).According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101.The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101.The input module 150 may include, for example, a microphone, a mouse, a keyboard, keys (e.g., buttons), or a digital pen (e.g., a stylus pen).

The sound output module 155 may output sound signals to the outside of the electronic device 101.The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101.The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102)directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102).According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101.According to an embodiment, the power management module 188 may be implemented as at least part of, for example, a power management integrated circuit (PMIC).

The battery 189 may supply power to at least one component of the electronic device 101.According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wiredly) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module).A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)).These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108.For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1 01.The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

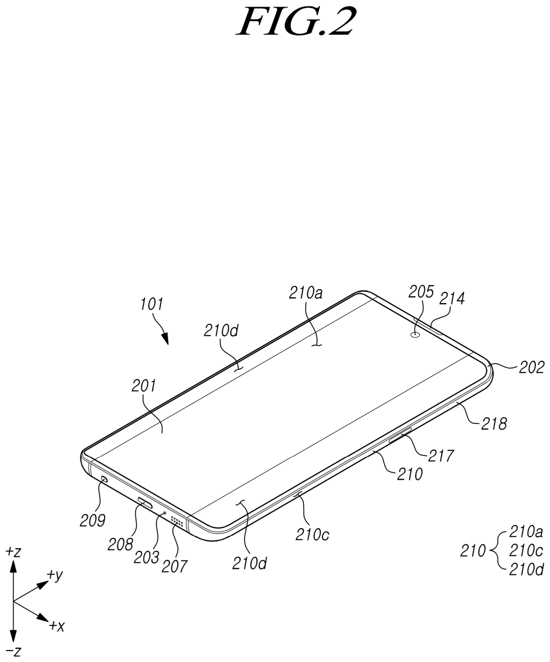

FIG. 2 is a front perspective view illustrating an electronic device 101 according to an embodiment.

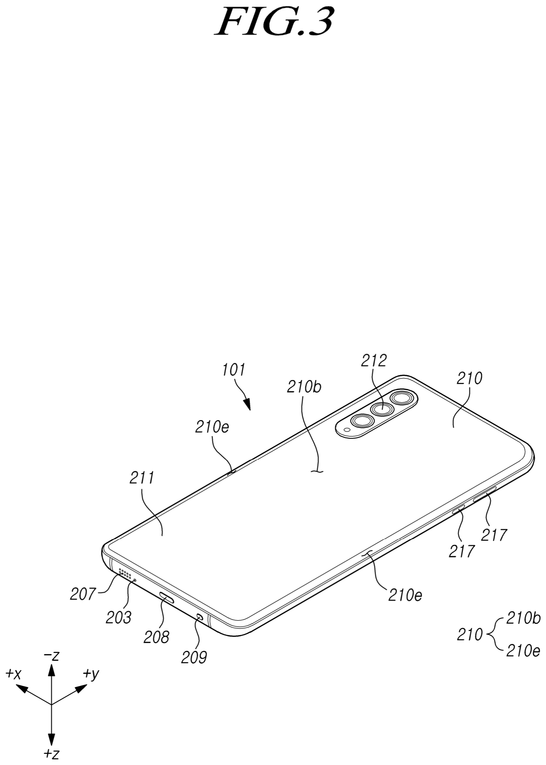

FIG. 3 is a rear perspective view illustrating an electronic device 101 according to an embodiment.

Referring to FIGS. 2 and 3, according to an embodiment, an electronic device 101 may include a housing 210 including a first surface (or front surface) 210A, a second surface (or rear surface) 210B, and a side surface 210C surrounding the space between the first surface 210A and the second surfaces 210B. According to another embodiment (not shown), the housing may denote a structure forming part of the first surface 210A, the second surface 210B, and the side surface 210C of FIG. 2. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., coated or colored glass, ceramic, polymer, metal (e.g., aluminum, stainless steel (STS), or magnesium), or a combination of at least two thereof. The side surface 210C may be formed by a side bezel structure (or a "side member") 218 that couples to the front plate 202 and the rear plate 211 and includes a metal and/or polymer. In some embodiments, the rear plate 211 and the side bezel structure 218 may be integrally formed and include the same material (e.g., a metal material such as aluminum).

In the embodiment illustrated, the front plate 202 may include two first areas 210D, which seamlessly and bendingly extend from the first surface 210A to the rear plate 211, on both the long edges of the front plate 202. In the embodiment (refer to FIG. 3) illustrated, the rear plate 211 may include second areas 210E, which seamlessly and bendingly extend from the second surface 210B to the front plate 202, on both the long edges. According to an embodiment, the front plate 202 (or the rear plate 211) may include only one of the first areas 210D (or the second areas 210E). Alternatively, the first areas 210D or the second areas 210E may partially be excluded. According to an embodiment, at side view of the electronic device 101, the side bezel structure 218 may have a first thickness (or width) for sides that do not have the first areas 210D or the second areas 210E and a second thickness, which is smaller than the first thickness, for sides that have the first areas 210D or the second areas 210E.

According to an embodiment, the electronic device 101 may include at least one or more of a display 201 (e.g., the display module 160 of FIG. 1), audio modules 203, 207, and 214, a sensor module (e.g., the sensor module 176 of FIG. 1), camera modules 205 and 212, a key input device 217, and connector holes 208 and 209. According to an embodiment, the electronic device 101 may exclude at least one (e.g., the key input device 217 or the light emitting element) of the components or may add other components.

According to an embodiment, the display 201 may be visible through, e.g., a majority portion of the front plate 202. According to an embodiment, at least a portion of the display 201 may be visible through the front plate 202 forming the first surface 210A and the first areas 210D of the side surface 210C. According to an embodiment, the edge of the display 201 may be formed to be substantially the same in shape as an adjacent outer edge of the front plate 202. According to another embodiment (not shown), the gap between the outer edge of the display 201 and the outer edge of the front plate 202 may remain substantially even to give a larger visible area of the display 201.

According to an embodiment (not shown), the screen display area of the display 201 may have a recess or opening in a portion thereof, and at least one or more of the audio module 170, sensor module 176, and camera module 205 may be aligned with the recess or opening. In another embodiment (not shown), at least one or more of the audio module 170, the sensor module 176, and the camera module 205 may be included on the rear surface of the screen display area of the display 201. In another embodiment (not shown), the display 201 may be disposed to be coupled with, or adjacent, a touch detecting circuit, a pressure sensor capable of measuring the strength (pressure) of touches, and/or a digitizer for detecting a magnetic field-type stylus pen. In an embodiment, at least part of the sensor modules 176 and/or at least part of the key input devices 217 may be disposed in the first areas 210D and/or the second areas 210E.

According to an embodiment, the audio modules 203, 207, and 214 may include a microphone hole 203 and speaker holes 207 and 214. A microphone for acquiring external sounds may be disposed in the microphone hole 203. In some embodiments, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be included without the speaker holes 207 and 214 (e.g., piezo speakers).

According to an embodiment, the sensor module 176 may generate an electrical signal or a data value corresponding to an internal operating state of the electronic device 101 or an external environmental state. The sensor module 176 may include a first sensor module (e.g., a proximity sensor) disposed on the first surface 210A of the housing 210, and/or a second sensor module (e.g., a fingerprint sensor), and/or a third sensor module (e.g., an HRM sensor) disposed on the second surface 210B of the housing 210, and/or a fourth sensor module (e.g., a fingerprint sensor). The fingerprint sensor may be disposed on the second surface 210B as well as on the first surface 210A (e.g., the display 201) of the housing 210. The electronic device 101 may include a sensor module not shown, e.g., at least one of a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205 and 212 may include a first camera module 205 disposed on the first surface 210A of the electronic device 101 and a second camera module 212 and/or a flash disposed on the second surface 210B. The camera modules 205 and 212 may include one or more lenses, an image sensor, and/or an image signal processor. The flash may include, e.g., a light emitting diode or a xenon lamp. In an embodiment, two or more lenses (an infrared (IR) camera, a wide-angle lens, and a telephoto lens) and image sensors may be disposed on one surface of the electronic device 101.

According to an embodiment, the key input device 217 may be disposed on the side surface 210C of the housing 210. According to another embodiment, the electronic device 101 may exclude all or some of the above-mentioned key input devices 217 and the excluded key input devices 217 may be implemented in other forms, e.g., as soft keys, on the display 201. According to an embodiment, the key input device may include the sensor module 216 disposed on the second surface 210B of the housing 210.

According to an embodiment, the light emitting element may be disposed on the first surface 210A of the housing 210, for example. The light emitting element may provide, e.g., information about the state of the electronic device 101 in the form of light. According to another embodiment, the light emitting device may provide a light source that interacts with, e.g., the camera module 205. The light emitting element may include, e.g., an light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

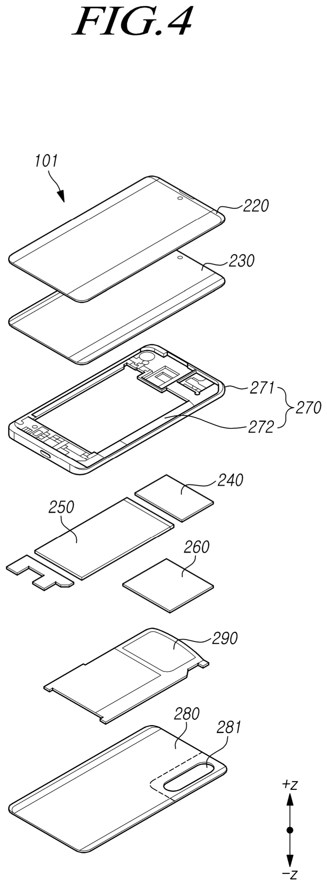

FIG. 4 is an exploded perspective view illustrating an electronic device 101 according to an embodiment.

Referring to FIG. 4, an electronic device 101 (e.g., the electronic device 101 of FIGS. 1 to 3) may include a supporting bracket 270, a front plate 220 (e.g., the front plate 202 of FIG. 2), a display 230 (e.g., the display 201 of FIG. 2), a printed circuit board 240 (e.g., a PCB, flexible PCB (FPCB), or rigid flexible PCB (RFPCB)), a battery 250 (e.g., the battery 189 in FIG. 1), a second supporting member 260 (e.g., a rear case), an antenna 290 (e.g., the antenna module 197 of FIG. 1), and a rear plate 280 (e.g., the rear plate 211 of FIG. 2). The supporting bracket 270 of the electronic device 101 according to an embodiment may include a side bezel structure 271 (e.g., the side bezel structure 218 of FIG. 2) and a first supporting member 272. At least one of the components of the electronic device 101 may be the same or similar to at least one of the components of the electronic device 101 of FIGS. 2 and 3 and no duplicate description is made below.

According to an embodiment, the first supporting member 272 may be disposed inside the electronic device 101 to be connected with the side bezel structure 271 or integrated with the side bezel structure 271. The first supporting member 272 may be formed of, e.g., a metal and/or non-metallic material (e.g., polymer). The display 230 may be joined onto one surface of the first supporting member 272, and the printed circuit board 240 may be joined onto the opposite surface of the first supporting member 272.

According to an embodiment, a processor, a memory, and/or an interface may be mounted on the printed circuit board 240. The processor may include one or more of, e.g., a central processing unit, an application processor, a graphic processing device, an image signal processing, a sensor hub processor, or a communication processor. According to various embodiments, the printed circuit board 240 may include a flexible printed circuit board type radio frequency cable (FRC). For example, the printed circuit board 240 may be disposed on at least a portion of the first supporting member 272 and may be electrically connected with an antenna module (e.g., the antenna module 197 of FIG. 1) and a communication module (e.g., the communication module 190 of FIG. 1).

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the battery 250 may be a device for supplying power to at least one component of the electronic device 101. The battery 189 may include, e.g., a primary cell which is not rechargeable, a secondary cell which is rechargeable, or a fuel cell. At least a portion of the battery 250 may be disposed on substantially the same plane as the printed circuit board 240. The battery 250 may be integrally or detachably disposed inside the electronic device 101.

According to various embodiments, the second supporting member 260 (e.g., a rear case) may be disposed between the printed circuit board 240 and the antenna 290. For example, the second supporting member 260 may include one surface to which at least one of the printed circuit board 240 and the battery 250 is coupled, and another surface to which the antenna 290 is coupled.

According to an embodiment, the antenna 290 may be disposed between the rear plate 280 and the battery 250. The antenna 290 may include, e.g., a near-field communication (NFC) antenna, a wireless charging antenna, and/or a magnetic secure transmission (MST) antenna. The antenna 290 may perform short-range communication with, e.g., an external device or may wirelessly transmit or receive power necessary for charging. According to an embodiment, an antenna structure may be formed by a portion or combination of the side bezel structure 271 and/or the first supporting member 272.

According to various embodiments of the disclosure, the electronic device may include a plurality of antenna modules 290. For example, some of the plurality of antenna modules 290 may be implemented to transmit or receive radio waves with different characteristics (referred to as radio waves of frequency bands A and B) to implement MIMO. As another example, some of the plurality of antenna modules 290 may be configured to transmit or receive radio waves with substantially the same characteristic (referred to as radio waves of frequencies A1 and A2 in frequency band A) to implement diversity. As another example, some of the plurality of antenna modules 290 may be configured to transmit or receive radio waves with substantially the same characteristic (referred to as radio waves of frequencies B1 and B2 in frequency band B) to implement diversity. In an embodiment of the disclosure, two antenna modules may be included. Alternatively, the electronic device 101 may include four antenna modules to implement both MIMO and diversity. According to another embodiment, the electronic device 101 may include only one antenna module 290.

According to an embodiment, given the transmission and reception nature of radio waves, in case that one antenna module is disposed in a first position of the printed circuit board 240, another antenna module may be disposed in a second position, which is separated from the first position, of the printed circuit board 240. As another example, one antenna module and another antenna module may be disposed considering the distance therebetween depending on diversity characteristics.

According to an embodiment, at least one antenna module 290 may include a wireless communication circuit to process radio waves transmitted or received in a ultra-high frequency band (e.g., 6GHz or more and 200GHz or less). The conductive plate of the at least one antenna module 290 may be formed of a dipole-structured conductive plate extending in one direction or a patch-type radiating conductor. A plurality of conductive plates may be arrayed to form an antenna array. A chip (e.g., an integrated circuit (IC) chip) in which part of the wireless communication circuit is implemented may be disposed on the opposite surface of the surface where the conductive plate is disposed or on one side of the area where the conductive plate is disposed and may be electrically connected with the conductive plate via a line which is formed of a printed circuit pattern.

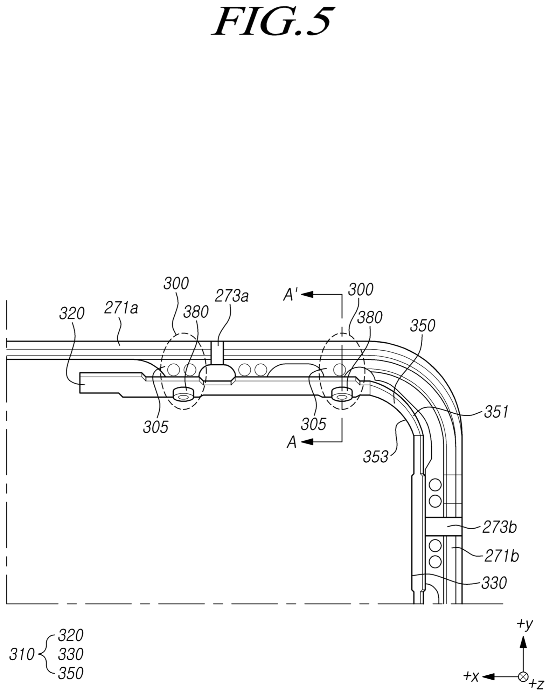

Hereinafter, a printed circuit board (e.g., the circuit board assembly 310 of FIG. 5) to be applied to the disclosure may be applied inside an electronic device 101. The circuit board assembly 310 may include one or a combination of two or more of a printed circuit board (PCB), a flexible printed circuit board (FPCB), or a flexible flat cable (FFC). The electronic device 101 is not limited to the bar-shaped device illustrated in FIGS. 2 to 4, and may include an electronic device 101 to which a foldable display or a rollable display (not illustrated) is applied.

According to an embodiment, as the functions provided by the electronic device 101 become diversified, the number of electrical components mounted inside the electronic device 101 may increase and the types may become diversified. Accordingly, there is a need to efficiently utilize the inner space of the electronic device 101 to arrange the electrical components.

According to an embodiment, as a method for efficiently utilizing the inner space of the electronic device 101, electrical components may be mounted on a front case (e.g., the first supporting member 272 of FIG. 4) and then a rear case (e.g., the second supporting member 260 of FIG. 4) may be fastened.

The circuit board assembly 310 may electrically and physically connect electrical components inside the electronic device 101. The circuit board assembly 310 to be described in the disclosure may be applied to a printed circuit board corresponding to a portion of a circuit included in an antenna module (e.g., the antenna module 197 of FIG. 1). An antenna circuit may be provided on the circuit board assembly 310, or an antenna pattern may be engraved. The circuit board assembly 310 may be connected to a main board (e.g., the printed circuit board 240 of FIG.4). The circuit board assembly 310 may be understood as a combination of a printed circuit board or a flexible printed circuit board disposed near the side frame 271 of the electronic device 101.

FIG. 5 is a diagram illustrating a plan view illustrating a circuit board assembly 310 connected to a side frame (e.g., the side bezel structure 271 of FIG. 4) of an electronic device (e.g., the electronic device 101 of FIG. 1), according to an embodiment.

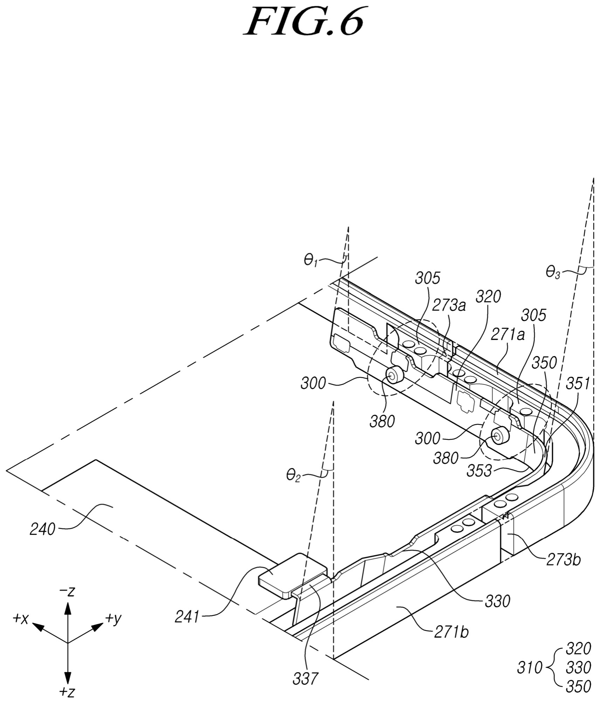

FIG. 6 is a perspective view illustrating a circuit board assembly 310 connected to the side frame 271 of the electronic device 101, according to an embodiment. For convenience of description, some components except for the housing 271 and the circuit board assembly 310 have been omitted.

Referring to FIGS. 5 and 6, these may be understood as plan and perspective views in case of viewing the electronic device 101 from the rear. Therefore, FIG. 5 may be understood as a view looking at the housing 271 and the circuit board assembly 310 from the rear toward the front direction (e.g., in the +z-axis direction) after removing the rear plate (e.g., the rear plate 280 of FIG. 4) from the electronic device 101. Hereinafter, descriptions such as "upper side", "lower side", "left side" or "right side" described herein are terms used for convenience of description in the drawings, and are not limited to specific positions thereby.

According to an embodiment, the side frame 271 may form the side exterior of the electronic device 101. The side frame 271 may include at least one material of metal or synthetic resin. The side frame 271 formed of metal material may form an antenna.

According to an embodiment, the side frame 271 may include a first side frame 271a and a second side frame 271b. The first side frame 271a may be defined as a frame positioned on the upper side in case of viewing the electronic device 101 from the front. The second side frame 271b may be defined as a frame positioned on the left side in case of viewing the electronic device 101 from the front. The side frame 271 may further include a third side frame positioned on the lower side and a fourth side frame positioned on the right side in case of viewing the electronic device 101 from the front.

According to an embodiment, a metal member 305 may be provided inside the side frame 271. The metal member 305 may be attached to the inner surface of the side frame 271. The metal member 305 and the side frame 271 may form a laminated structure. The metal member 305 may also be implemented integrally with the side frame 271.

According to an embodiment, the metal member 305 may include a conductive material. For example, the metal member 305 may include a metal material.

According to an embodiment, the metal member 305 may be provided to radiate an antenna signal from an antenna feeding structure 300. The metal member 305 may radiate an antenna signal based on current supplied from a feeding unit 301.

According to an embodiment, the side frame 271 and the metal member 305 may include an insulating member 273. The insulating member 273 may be formed of a non-conductive material provided in a space where a portion of the side frame 271 has been removed. The insulating member 273 may include a first insulating member 273a provided at an arbitrary point on the first side frame 271a. The insulating member 273 may include a second insulating member 273b provided at an arbitrary point on the second side frame 271b. Although not illustrated, the insulating member 273 may further include insulating members (not illustrated) provided at arbitrary points on the side frame 271 as needed.

According to an embodiment, the circuit board assembly 310 may be disposed along the side frame 271. The circuit board assembly 310 may be disposed along the first side frame 271a and the second side frame 271b. In other words, the rear surface of the circuit board assembly 310 may be disposed to face the side frame 271. Accordingly, integration of electrical components mounted on the front case 272 may be achieved.

According to an embodiment, the circuit board assembly 310 may be bent near an edge where the first side frame 271a and the second side frame 271b meet. For the circuit board assembly 310 to be bent near the edge, the circuit board assembly 310 may include a flexible printed circuit board 350 (hereinafter referred to as FPCB).

According to an embodiment, the FPCB 350 may be bent near the edge where the first side frame 271a and the second side frame 271b meet.

According to an embodiment, the circuit board assembly 310 may include a first printed circuit board 320 (hereinafter referred to as first PCB), a second printed circuit board 330 (hereinafter referred to as second PCB), and an FPCB 350. The first PCB 320 and the second PCB 330 may be connected to two opposite sides of the FPCB 350.

According to an embodiment, an antenna pattern (not illustrated) may be provided on the front or rear surface of the circuit board assembly 310. The antenna pattern may be formed of a conductive member of the circuit board assembly 310. The antenna pattern may be freely redesigned within a space formed inside the rear case (e.g., the second supporting member 260 of FIG. 4). For example, the antenna pattern may be provided on the front and rear surfaces of the first PCB 320, or may be provided on the front and rear surfaces of the second PCB 330.

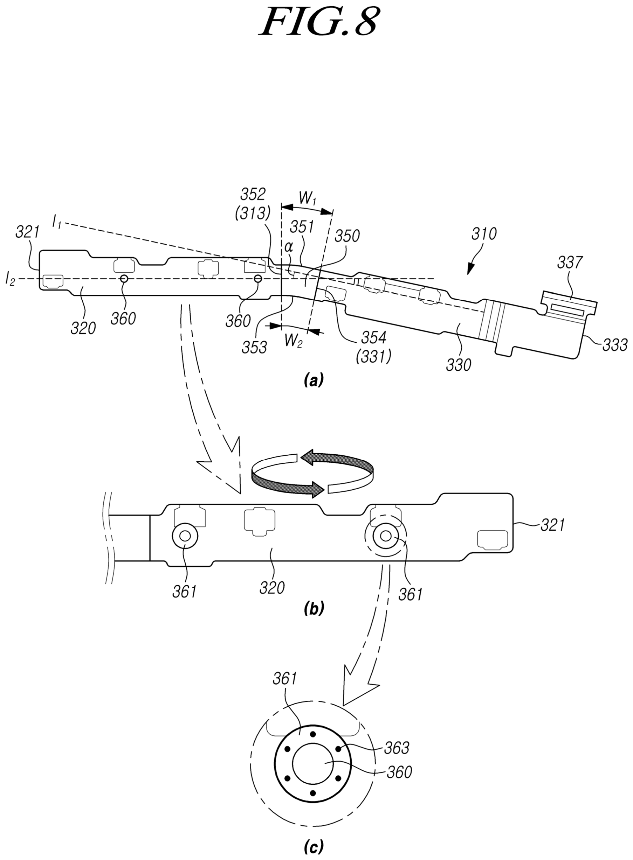

According to an embodiment, the circuit board assembly 310 may connect the metal member 305 included in the antenna feeding structure 300 and a printed circuit board (e.g., the printed circuit board 240 of FIG. 4). A connecting member (e.g., the connecting member 337 of FIG. 8) provided at one end of the circuit board assembly 310 may be connected to a connector 241 provided on the printed circuit board 240.

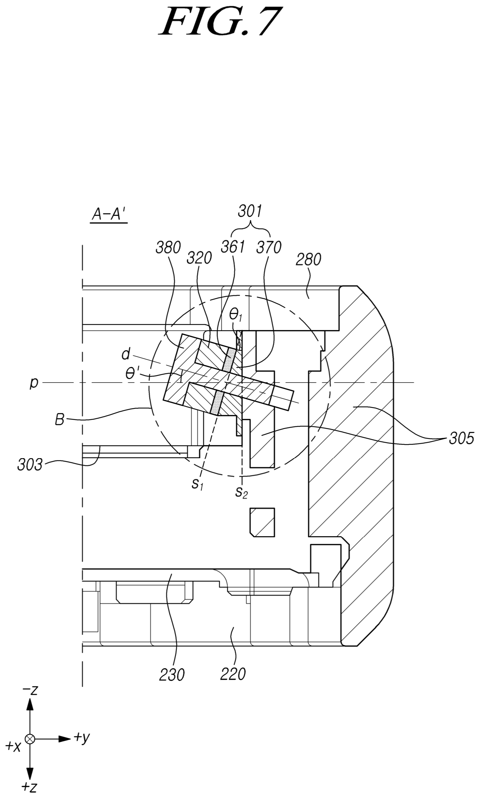

According to an embodiment, a screw 380 for fixing the circuit board assembly 310 to the metal member 305 may be provided. The screw 380 may be fastened to the metal member 305 by penetrating through a point of the circuit board assembly 310, a metal sheet (e.g., the metal sheet 370 of FIG. 7), and a casing member 303. The screw 380 may be fixed to the metal member 305 by penetrating through a through hole (e.g., the through hole 360 of FIG. 7) provided on the rear surface of the first PCB 320.

According to an embodiment, the antenna feeding structure 300 may be formed by fixing the circuit board assembly 310, the metal sheet 370, and the casing member 303 to the metal member 305 with the screw 380. The antenna feeding structure 300 may include a feeding unit (e.g., the feeding unit 301 of FIG. 7) for supplying current necessary to radiate wireless signals. The feeding unit 301 may be implemented with at least a portion of the circuit board assembly 310 and the metal sheet 370. The feeding unit 301 may include a feeding point or a feeding line.

According to an embodiment, at least one or more screws 380 may be provided. The screw 380 may be provided to fix the first PCB 320 to the metal member 305 as illustrated. The screw 380 may include a first screw or a second screw. Further, not limited to what is illustrated, the screw 380 may further include at least one or more screws (not illustrated) for fixing the second PCB 330 to a metal member provided on the second side frame 271b. The second PCB 330 may be further provided with a through hole through which the at least one or more screws pass. In the disclosure, it is assumed that the screw 380 is provided to fasten the first PCB 320 of the circuit board assembly 310 to the metal member 305.

According to an embodiment, the screw 380 may be fastened to the metal member 305 by penetrating perpendicular to the circuit board assembly 310.

According to an embodiment, the circuit board assembly 310 may be disposed to be inclined at a predetermined angle with the side frame 271. The predetermined angle may have a range of, e.g., 10° to 20°. In other words, the following first angle to third angle (θ1, θ2, θ3) may have a range of 10° to 20°. For example, the angle formed between the first PCB 320 and the first side frame 271a may be defined as a first angle θ1. For example, the angle formed between the second PCB 330 and the second side frame 271b may be defined as a second angle θ2. For example, the angle formed between the FPCB 350 and the edge where the first side frame 271a and the second side frame 271b meet may be defined as a third angle θ3.

According to an embodiment, the first angle θ1, the second angle θ2, and the third angle θ3 may be the same.

According to an embodiment, at least two angles among the first angle θ1, the second angle θ2, and the third angle θ3 may be the same.

For example, among the first angle θ1, the second angle θ2, and the third angle θ3, the first angle θ1 and the second angle θ2 may be the same, and the third angle θ3 may be different from the first angle θ1 and the second angle θ2.

For example, among the first angle θ1, the second angle θ2, and the third angle θ3, the second angle θ2 and the third angle θ3 may be the same, and the second angle θ2 may be different from the first angle θ1 and the third angle θ3.

For example, among the first angle θ1, the second angle θ2, and the third angle θ3, the second angle θ2 and the third angle θ3 may be the same, and the first angle θ1 may be different from the second angle θ2 and the third angle θ3.

According to an embodiment, the first angle θ1, the second angle θ2, and the third angle θ3 may all be different.

According to an embodiment, the first angle θ1, the second angle θ2, and the third angle θ3 may have free values within a preset range, but for convenience of description below, it is assumed that the circuit board assembly 310 is inclined at the same angle with respect to the side frame 271. In other words, it is assumed that the first angle θ1, the second angle θ2, and the third angle θ3 are all the same.

According to an embodiment, since the circuit board assembly 310 is inclined at a predetermined angle, physical interference between a fastening device (not illustrated) (e.g., a screwdriver) for fastening the screw 380 and peripheral mechanical portions mounted on the electronic device 101 (e.g., electrical components, the casing member 303 (e.g., the front case 272 or the rear case 260) or a housing (e.g., the support bracket 270 of FIG. 4)) may be minimized. Accordingly, the ease of fastening between the circuit board assembly 310 and the housing (e.g., the support bracket 270 of FIG. 4) may be enhanced.

For example, as the first angle to third angle (θ1, θ2, θ3) increases, physical interference between the circuit board assembly 310 and the peripheral mechanical portions may decrease. Therefore, as the first angle to third angle (θ1, θ2, θ3) increases, the ease of fastening of the circuit board assembly 310 may increase.

For example, as the first angle to third angle (θ1, θ2, θ3) increases, the space for the screw 380 to be fastened to the metal member 305 through the circuit board assembly 310 may decrease. Considering this, the first angle to third angle (θ1, θ2, θ3) may be substantially 10° to 20°.

According to an embodiment, for the circuit board assembly 310 to be disposed inclined with respect to the side frame 271, a length of a first open end 351 and a second open end 353 of the FPCB 350 may be different. A length w1 of the first open end 351 may be longer than a length w2 of the second open end 353.

According to an embodiment, the difference between the length w1 of the first open end 351 and the length w2 of the second open end 353 may vary corresponding to the first angle to third angle (θ1, θ2, θ3). Since the FPCB 350 is implemented with a flexible material, the first open end 351 and the second open end 353 may stretch or shrink within a movable range.

For example, as the first angle to third angle (θ1, θ2, θ3) increases, the difference between the length w1 of the first open end 351 and the length w2 of the second open end 353 may increase.

For example, as the first angle to third angle (θ1, θ2, θ3) decreases, the difference between the length w1 of the first open end 351 and the length w2 of the second open end 353 may decrease.

For example, as the first angle to third angle (θ1, θ2, θ3) approaches 0, e.g., as the circuit board assembly 310 is disposed parallel to the side frame 271, the length w1 of the first open end 351 and the length w2 of the second open end 353 may be substantially the same.

According to an embodiment, since the circuit board assembly 310 is disposed inclined at a predetermined angle (e.g., the first angle to third angle (θ1, θ2, θ3)) with respect to the side frame 271, a feeding point may be provided at a point adjacent to the side frame 271. As the feeding point is disposed closer to the side frame 271, the distance between electrical components adjacent to the antenna feeding structure 300 and the feeding point increases, thereby minimizing electrical interference. Therefore, the radiation performance of the antenna may be enhanced.

FIG. 7 is a cross-sectional view illustrating an electronic device (e.g., the electronic device 101 of FIG. 1), according to an embodiment. FIG. 7 may be understood as a view looking at a cross-section taken along line A-A' of FIG. 5 in the +x-axis direction.

Referring to FIG. 7, the antenna feeding structure 300 may include a side frame (e.g., the side frame 271 of FIG. 5), a circuit board assembly (e.g., the circuit board assembly 310 of FIG. 5), a metal sheet 370, and a screw 380.

According to an embodiment, the casing member 303 may be formed as at least a portion of a front case (e.g., the front case 272 of FIG. 4), or may be separately provided on one surface of the front case 272. The casing member 303 may be provided to mount elements included in the antenna feeding structure 300 (e.g., the circuit board assembly 310 or the metal sheet 370). One surface of the casing member 303 may contact one surface of the side frame 271.

According to an embodiment, a metal sheet 370 may be disposed on an inner surface of the casing member 303 contacting the side frame 271. The metal sheet 370 may be provided to prevent passive inter-modulation distortion (hereinafter referred to as PIMD) phenomenon. PIMD may be understood as a phenomenon in which noise is generated due to two or more transmission signal frequencies interfering with each other due to nonlinearity of passive components in wireless communication. As a method to minimize the PIMD phenomenon, a metal sheet 370 formed of metal material to minimize nonlinearity between metals may be disposed on the inner surface of the casing member 303.

According to an embodiment, the metal sheet 370 may be attached to the inner surface of the casing member 303. The metal sheet 370 and the inner surface of the casing member 303 may be attached through an ultrasonic bonding method.

According to an embodiment, the metal sheet 370 may be manufactured by plating a metal member with gold-cobalt (Au-Co) material. The size of the metal sheet 370 may be implemented as, e.g., 2mm in width and 2mm in height. However, without limitations thereto, the size of the area occupied by the metal sheet 370 may be variously determined in consideration of the manufacturing process, the attachment point, and surrounding components.

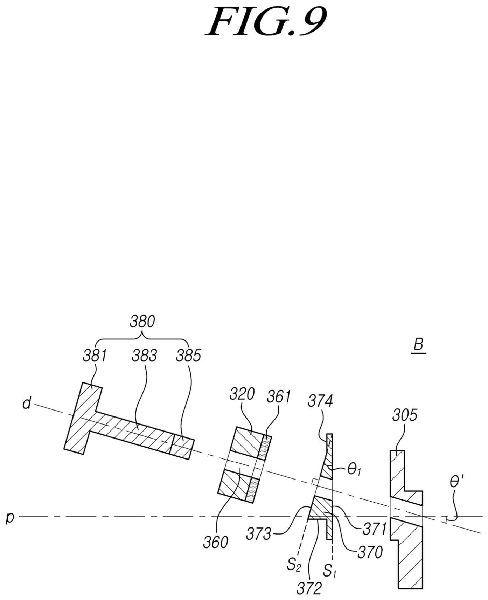

According to an embodiment, one surface of the metal sheet 370 may contact the inner surface of the casing member 303. Another surface opposite to the one surface may contact at least a partial surface of the first PCB 320. Here, one surface where the metal sheet 370 contacts the casing member 303 may be defined as a first surface (e.g., the first surface 371 of FIG. 9), and another surface where the metal sheet 370 contacts at least a partial surface of the first PCB 320 may be defined as a second surface (e.g., the second surface 373 of FIG. 9).

According to an embodiment, to arrange the first PCB 320 at a predetermined angle (e.g., the first angle θ1) with respect to the first side frame 271a, the first surface 371 and the second surface 373 of the metal sheet 370 may form a predetermined angle. The predetermined angle may be, e.g., the same as the first angle θ1.

According to an embodiment, by the first surface 371 and the second surface 373 of the metal sheet 370 forming a predetermined angle, the first PCB 320 may be disposed to be inclined at the first angle θ1 with respect to the first side frame 271a.

According to an embodiment, the rear surface of the first PCB 320 may be disposed on the second surface 373 of the metal sheet 370.

According to an embodiment, a ring-shaped washer 361 covering an outer circumferential surface of a through hole (e.g., the through hole 360 of FIG. 8) may be provided on the rear surface of the first PCB 320. The washer 361 may have a shape like a flat washer. The washer 361 may include a metal material and have conductivity.

According to an embodiment, the washer 361 may electrically connect the first PCB 320 and the metal sheet 370. Since the first PCB 320 is provided with the washer 361, the first PCB 320 and the metal sheet 370 may be stably connected. Further, the washer 361 may evenly distribute the force acting from insertion of the screw 380. Accordingly, the washer 361 may prevent wear or damage due to contact with the metal sheet 370.

According to an embodiment, the washer 361 may have various shapes in addition to a ring shape. For example, the washer 361 may have a "C" shape with a predetermined point opened. For example, the washer 361 may be implemented as a spring washer and have a twisted coil shape. Further, the washer 361 may have various shapes corresponding to the form of a washer.

According to an embodiment, at least one or more protrusions (e.g., the protrusion 363 of FIG. 8) may be provided on a surface where the washer 361 contacts the metal sheet 370. The protrusions 363 may be formed on the surface with a predetermined pattern. By providing the protrusions 363, the electrical connection between the first PCB 320 and the metal sheet 370 may be provided more stably.

According to an embodiment, the screw 380 may fix the first PCB 320 and the metal sheet 370 mounted on the casing member 303 to the first side frame 271a. The screw 380 may be fastened to the first side frame 271a by passing through a through hole 360 provided in the first PCB 320 and penetrating the metal sheet 370.

According to an embodiment, a tip of the screw 380 (hereinafter referred to as a screw tip) may be fixed at a predetermined point of the first side frame 271a. In case that threads are formed on the screw tip, a fastening portion (not illustrated) having a shape corresponding to the threads may be provided at the predetermined point.

According to an embodiment, the screw 380 may be fastened in a perpendicular direction to the second surface 373 of the metal sheet 370. Therefore, the angle formed between a fastening direction d of the screw 380 and the second surface 373 may form substantially 90°.

According to an embodiment, the fastening direction d of the screw 380 and an auxiliary line p may form a predetermined angle θ'. Here, the auxiliary line p may be parallel to the x-y plane. The predetermined angle θ' may be substantially the same as the first angle θ1. However, the predetermined angle θ' may be determined within the range of angles having the first angle to third angle (θ1, θ2, θ3) according to the arrangement angle of the circuit board assembly 310.

According to an embodiment, the antenna feeding structure 300 may be mounted in the following manner. However, without limitations thereto, the mounting sequence to be described below may be changed as necessary.

According to an embodiment, the casing member 303 may be disposed on the electronic device 101 disposed on its rear surface. Accordingly, the electronic device 101 may dispose the casing member 303 with the front plate 220 (e.g., the front plate 220 of FIG. 2) and the display 230 (e.g., the display 230 of FIG. 2) disposed on the lower surface. One surface of the casing member 303 may contact one surface of the metal member 305 contacting the inner surface of the side frame 271.

According to an embodiment, the metal sheet 370 may be disposed to contact the inner surface of the casing member 303. The first surface 371 of the metal sheet 370 may be disposed to contact the inner surface.

According to an embodiment, the second surface 373 of the metal sheet 370 may be disposed to contact the rear surface of the first PCB 320. One surface of the washer 361 covering the through hole 360 provided in the first PCB 320 may contact the second surface 373.

According to an embodiment, the screw 380 may be fixed to the first side frame 271a by passing through the through hole 360 provided in the first PCB 320 and penetrating the metal sheet 370 and the casing member 303.

According to an embodiment, a feeding unit (e.g., the feeding unit 301 of FIG. 5) may be formed by some components in the antenna feeding structure 300. For example, the metal sheet 370 and the washer 361 connected by the screw 380 may form the feeding unit 301.

According to an embodiment, the washer 361 covering the through hole 360 provided in the first PCB 320 may be a starting point of the feeding unit 301. The starting point of the feeding unit 301 may be formed as a metal-to-metal contact point in the antenna feeding structure 300.

According to an embodiment, since the circuit board assembly 310 is disposed inclined at a predetermined angle with respect to the side frame 271, a point for fastening the screw 380 for fastening the circuit board assembly 310 to the metal member 305 may form a predetermined angle θ' with the lower surface (e.g., the x-y plane). Accordingly, the antenna feeding structure 300 of the disclosure may provide ease of fastening of the screw 380.

According to an embodiment, since the circuit board assembly 310 is disposed inclined at a predetermined angle with respect to the side frame 271 and the screw 380 is fastened in a perpendicular direction to the circuit board assembly 310, the starting point of the feeding unit 301 may be formed at a point adjacent to the side frame 271. In other words, the starting point of the feeding unit 301 may be formed to be biased toward the outside (e.g., +y direction) of the electronic device 101. As the starting point of the feeding unit 301 is formed at a point closer to the side frame 271, the radiation point in the antenna feeding structure 300 may be farther from electrical components mounted inside the electronic device 101. Accordingly, the radiation efficiency of the antenna increases, thereby providing enhanced antenna performance.

FIG. 8 is a front view illustrating the circuit board assembly 310 (e.g., the circuit board assembly 310 of FIG. 5) in an unfolded state, according to an embodiment. FIG. 8(a) is a view looking at the circuit board assembly 310 in an unfolded state from the front, (b) is a view looking at the rear surface of the first PCB 320 of the circuit board assembly 310 symmetrically reversed left and right, and (c) is an enlarged view illustrating the through hole 360 (e.g., the through hole 360 of FIG. 7) provided on the rear surface of the first PCB 320.

Referring to FIG. 8, the circuit board assembly 310 may include a first PCB 320, a second PCB 330, and an FPCB 350. The circuit board assembly 310 may be formed as a rigid flexible printed circuit board (R-FPCB) combining a rigid printed circuit board (R-PCB) and a flexible printed circuit board (F-PCB). The circuit board assembly 310 may be disposed inclined at a predetermined angle (e.g., the first angle θ1 of FIG. 6) with respect to the side frame 271.

According to an embodiment, electrical components may be mounted on the first PCB 320 or the second PCB 330. Electrical components with antenna patterns engraved may be mounted on the first PCB 320 or the second PCB 330. The electrical components may be mounted on the front or rear surface of the first PCB 320. The electrical components may be mounted on the front or rear surface of the second PCB 330.

According to an embodiment, the front surface of the first PCB 320 may be provided as a non-conductive surface, and the rear surface may be provided as a conductive surface. An electrical line for the feeding unit 301 may be provided on the rear surface of the first PCB 320.

According to an embodiment, the circuit board assembly 310 may include an FPCB 350 to be bent near the edge where the first side frame (e.g., the first side frame 271a of FIG. 5) and the second side frame (e.g., the second side frame 271b of FIG. 5) meet.

According to an embodiment, the first PCB 320 and the second PCB 330 may be electrically and/or physically connected to two opposite sides of the FPCB 350. For example, a first side surface 352 of the FPCB 350 and a second side surface 323 of the first PCB 320 may be connected. For example, a second side surface 354 of the FPCB 350 and a first side surface 331 of the second PCB 330 may be connected.

According to an embodiment, a through hole 360 through which a screw (e.g., the screw 380 of FIG. 5) passes may be provided at a predetermined point of the first PCB 320. Although not illustrated, the through hole 360 may also be provided on the second PCB 330 as needed.

According to an embodiment, in case that a plurality of through holes 360 are provided, they may be formed at the same height on the first PCB 320. However, without limitations thereto, the plurality of through holes 360 may be formed at different heights.

According to an embodiment, a ring-shaped washer 361 covering the outer circumferential surface of the through hole 360 may be provided on the rear surface of the first PCB 320. The ring-shaped washer 361 may also be referred to as a sus-ring. As necessary, the washer 361 may be omitted.

According to an embodiment, at least one or more protrusions 363 may be provided at a predetermined point of the washer 361. The one or more protrusions 363 may be referred to as embossing. The one or more protrusions 363 may be provided on one surface of the washer 361 as an embossed pattern having a predetermined shape. By providing the one or more protrusions 363, the electrical connection between the first PCB 320 and the metal sheet 370 may be stably provided.

According to an embodiment, a connecting member 337 may be provided near the other end opposite to one end where the second PCB 330 is connected to the FPCB 350. The connecting member 337 may include a flexible material and may be bent. The connecting member 337 may be connected to a connector provided on a printed circuit board (e.g., the printed circuit board 240 of FIG. 4).

According to an embodiment, for the circuit board assembly 310 to be disposed inclined at a predetermined angle with respect to the side frame 271, the circuit board assembly 310 in an unfolded state may have a shape as illustrated in (a). In other words, a length direction 11 of the first PCB 320 and a length direction 12 of the second PCB 330 may not coincide with each other. Hereinafter, for convenience of description, the length direction 11 of the first PCB 320 is defined as a first length direction 11, and the length direction l2 of the second PCB 330 is defined as a second length direction l2. Here, the first length direction 11 may be defined as the length direction of the first PCB 310, and the second length direction 12 may be defined as the length direction of the second PCB 330.

According to an embodiment, the first length direction 11 and the second length direction 12 may form a predetermined angle α. The predetermined angle α is defined as a fourth angle α. The fourth angle α may be an acute angle from 0° to 90°. The fourth angle α may be set in consideration of a predetermined angle (e.g., the first angle θ1) where the circuit board assembly 310 is inclined with respect to the side frame 271.

For example, as the angle where the circuit board assembly 310 is inclined with respect to the side frame 271 increases, the fourth angle α will increase.

For example, as the angle where the circuit board assembly 310 is inclined with respect to the side frame 271 decreases, the fourth angle α will decrease.

According to an embodiment, for the circuit board assembly 310 to be disposed inclined at a predetermined angle with respect to the side frame 271, a length w1 of an upper side 351 of the open end of the FPCB 350 (hereinafter referred to as the first open end) and a length w2 of a lower side 353 of the open end (hereinafter referred to as the second open end) may be different from each other. For example, the length w1 of the first open end 351 may be longer than the length w2 of the second open end 353.

According to an embodiment, the difference between the length w1 of the first open end 351 and the length w2 of the second open end 353 may vary corresponding to the first angle θ1. Since the FPCB 350 is implemented with a flexible material, the first open end 351 and the second open end 353 may stretch or shrink within a movable range.

For example, as the first angle θ1 increases, the difference between the length w1 of the first open end 351 and the length w2 of the second open end 353 may increase.

For example, as the first angle θ1 decreases, the difference between the length w1 of the first open end 351 and the length w2 of the second open end 353 may decrease.

For example, as the first angle θ1 approaches 0, e.g., as the circuit board assembly 310 is disposed parallel to the side frame 271, the length w1 of the first open end 351 and the length w2 of the second open end 353 may be substantially the same.

According to an embodiment, the difference between the length w1 of the first open end 351 and the length w2 of the second open end 353 may increase corresponding to the fourth angle α. For example, as the fourth angle α increases, the difference between the length w1 of the first open end 351 and the length w2 of the second open end 353 may increase. For example, as the fourth angle α decreases, the difference between the length w1 of the first open end 351 and the length w2 of the second open end 353 may decrease.

FIG. 9 is a cross-sectional view in an exploded state of the antenna feeding structure 300, according to an embodiment. In other words, FIG. 9 may be understood as a cross-sectional view in a state where the components of portion B of FIG. 7 are exploded. For convenience of description, some components (e.g., the casing member 303 of FIG. 7) may be omitted.

Referring to FIG. 9, the antenna feeding structure 300 may include a metal member 305, a metal sheet 370, and a first PCB 320.

According to an embodiment, the metal sheet 370 may have a first surface 371, a second surface 373, a third surface 372, and a fourth surface 374.

According to an embodiment, the first surface 371 may contact the inner surface of the casing member 303. The length of the first surface 371 may be substantially the same as or shorter than the height where the casing member 303 extends in the z-axis direction.

According to an embodiment, the second surface 373 may contact one surface of the washer 361 covering the through hole 360 provided on the rear surface of the first PCB 320. The length of the second surface 373 may be substantially the same as or longer than the diameter of the washer 361.

According to an embodiment, the first surface 371 and the second surface 373 may form a predetermined angle. Due to the predetermined angle, the first PCB 320 may be disposed to be inclined at a predetermined angle with respect to the side frame 271a. The predetermined angle may be defined as, e.g., the first angle θ1.

According to an embodiment, as the first angle θ1 increases, the screw 380 may be fastened in a state inclined by the first angle θ1 in the height direction (e.g., -z-axis direction) with respect to the lower surface (e.g., the surface on which the front plate 220 or the display 230 of the electronic device 101 is disposed). Accordingly, in case of fastening the screw 380, physical interference between a fastening device (e.g., a screwdriver) and components existing around the fastening device may be minimized. Therefore, the ease of fastening of the screw 380 may be enhanced.

According to an embodiment, as the first angle θ1 increases, the starting point of the feeding unit (e.g., the feeding unit 301 of FIG. 7) may be positioned adjacent to the metal member 305. Accordingly, as the starting point of the feeding unit 301 moves away from electrical components mounted in the electronic device 101, interference with antenna radiation performance may be minimized. Therefore, the radiation performance of the antenna may be enhanced.

According to an example, the third surface 372 may be understood as the lower surface of the metal sheet 370. A catching jaw (not illustrated) may be provided at a point where one end of the third surface 372 and one end of the second surface 373 meet. The catching jaw may support the washer 361 by contacting a portion of the side surface of the washer 361.

According to an embodiment, the angle formed by the third surface 372 and the first surface 371 may be substantially 90°.

According to an embodiment, the fourth surface 374 may be connected to the other end of the second surface 373. The fourth surface 374 may support the washer 361 by contacting a portion of the side surface of the washer 361. The fourth surface 374 may be omitted as necessary.

According to an embodiment, the metal sheet 370 may have a shape of a triangular prism with a cross-section cut in the y-z plane being substantially a right triangle. However, without limitations thereto, the metal sheet 370 may also have a shape of a quadrilateral prism with the cross-section being substantially trapezoidal. In case that the cross-section of the metal sheet 370 is trapezoidal, the metal sheet 370 may have a shape of a quadrilateral prism with the lower surface (e.g., the third surface 372 of the metal sheet 370) being longer than the upper surface.

According to an embodiment, since the first surface 371 of the metal sheet 370 forms a predetermined angle with the second surface 373, the first PCB 320 seated on the second surface 373 of the metal sheet 370 may be disposed to be inclined at a predetermined angle with respect to the first side frame 271a.

According to an embodiment, the screw 380 may fix the first PCB 320 and the metal sheet 370 to the first side frame 271a by passing through the through hole 360 provided in the first PCB 320. A path corresponding to the shape of a thread 383 of the screw 380 may be provided as an empty space in the metal sheet 370 or the metal member 305.

According to an embodiment, the screw 380 may include a head 381, a thread 383, and a tip 385. The screw 380 may fasten the elements of the antenna feeding structure 300 while proceeding in the fastening direction d.

According to an embodiment, the fastening direction d of the screw 380 may be perpendicular to the surface on which the first PCB 320 is seated on the second surface 373 of the metal sheet 370. Accordingly, the fastening angle of the screw 380 may form a predetermined angle (e.g., the first angle θ1) with one surface (e.g., the x-y plane) of the electronic device 101. Accordingly, the ease of fastening of the screw 380 may be enhanced.

According to an embodiment, the head 381 may be partially removed or recessed to correspond to the shape of the tip portion of a fastening device (e.g., a screwdriver). A portion of the head 381 may contact one surface of the metal member 305.

According to an embodiment, the thread 383 may be fastened with a portion of the metal sheet 370, the casing member (the casing member 303 of FIG. 7), and the metal member 305 by passing through the through hole 360 provided in the first PCB 320.

According to an embodiment, the tip 385 may be implemented with one end having a pointed shape to penetrate the metal sheet 370, the casing member 303, and the metal member 305.

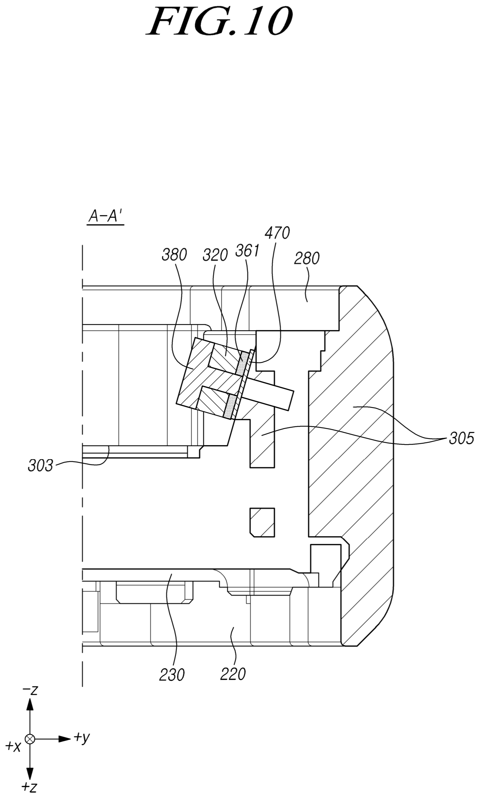

FIG. 10 is a cross-sectional view illustrating an electronic device (e.g., the electronic device 101 of FIG. 1), according to an embodiment. FIG. 10 may be understood as illustrating an antenna feeding structure 300 with a different shape of the metal sheet 370 applied in FIG. 7. Hereinafter, the differences from FIG. 7 are mainly described.

According to an embodiment, the casing member 303 may correspond to the casing member 303 of FIG. 7. However, one surface of the casing member 303 contacting the metal member 305 may be injection-molded to be inclined at a predetermined angle. The predetermined angle may correspond to the first angle (e.g., the first angle θ1 of FIG. 6). To that end, one surface of the metal member 305 contacting the casing member 303 may be injection-molded as an inclined surface inclined by the predetermined angle.

According to an embodiment, the metal sheet 470 may have the shape of a metal plate having a predetermined thickness. The metal sheet 470 may be attached to the inner surface opposite to one surface where the casing member 303 and the metal member 305 contact.

According to an embodiment, the first PCB 320 may be seated on one surface of the metal sheet 470. One surface of the metal sheet 470 may contact one surface of the washer 361 covering the through hole (e.g., the through hole 360 of FIG. 8) of the first PCB 320.

According to an embodiment, the screw 380 may fix the first PCB 320, the metal sheet 470, and the casing member 303 to the metal member 305 by passing through the through hole 360 provided in the first PCB 320.

According to an embodiment, since the surface where the first side frame 271a and the casing member 303 contact is formed as an inclined surface having a predetermined angle, the metal sheet 470 and the first PCB 320 are disposed on the inner surface of the casing member 303, and the screw 380 is fastened in a perpendicular direction to the first PCB 320, the fastening angle of the screw 380 may form a predetermined angle with the lower surface. Accordingly, the ease of fastening of the screw 380 may be enhanced. Further, the starting point of the feeding unit 301 may be positioned adjacent to the metal member 305. Accordingly, as the starting point of the feeding unit 301 moves away from electrical components mounted in the electronic device 101, interference with antenna radiation performance may be minimized. Therefore, the radiation performance of the antenna may be enhanced.

An electronic device 101, 200 (e.g., the electronic device 101 of FIG. 1 or the electronic device 200 of FIG. 2) according to an embodiment of the disclosure may include a frame 271, a metal member 305 provided inside the frame 271, a metal sheet 370 disposed such that a first surface 373 faces a printed circuit board 320 (e.g., the first PCB 320 of FIG. 5) and a second surface 373 opposite to the first surface 373 faces the metal member 305, and a screw 380 provided to penetrate and fasten through the printed circuit board 320, the metal sheet 370, and the metal member 305 sequentially. The metal sheet 370 may have the first surface 373 inclined at a predetermined angle θ1 relative to the second surface 373.

An electronic device 101, 200 according to an embodiment of the disclosure may include a washer 361 disposed between the printed circuit board 320 and the metal sheet 370.

In an electronic device 101, 200 according to an embodiment of the disclosure, the washer 361 may be of a metal material.

In an electronic device 101, 200 according to an embodiment of the disclosure, the printed circuit board 320 may be inclined at the predetermined angle θ1 and disposed substantially parallel to the first surface.

In an electronic device 101, 200 according to an embodiment of the disclosure, the metal sheet 370 may be fused to a casing member 303.

In an electronic device 101, 200 according to an embodiment of the disclosure, the casing member 303 may be a front case 272.

In an electronic device 101, 200 according to an embodiment of the disclosure, a third surface disposed to face the first surface 373 in the printed circuit board 320 may be a conductive surface, and a fourth surface opposite to the third surface may be a non-conductive surface.

In an electronic device 101, 200 according to an embodiment of the disclosure, the printed circuit board 320 may include electrical line for feeding power from the fourth surface to the screw 380.

In an electronic device 101, 200 according to an embodiment of the disclosure, the screw 380 may be fastened to the printed circuit board 320, the metal sheet 370, and the metal member 305 by a side screw fastening method.

In an electronic device 101, 200 according to an embodiment of the disclosure, the screw 380 may have a structure fastened to enable feeding power to the washer 361 and the metal sheet 370.

In an electronic device 101, 200 according to an embodiment of the disclosure, the printed circuit board 310 (e.g., the circuit board assembly 310 of FIG. 8) may be a rigid flexible printed circuit board (RF PCB) having rigid portions 320, 330 provided on at least one side of a flexible portion (e.g., the FPCB 350 of FIG. 8).

In an electronic device 101, 200 according to an embodiment of the disclosure, the screw 380 may be fastened through the rigid portions 320, 330.

In an electronic device 101, 200 according to an embodiment of the disclosure, the printed circuit board 320 may have a tilt structure bent at a predetermined angle α in a width direction as one side edge (e.g., the first open end 351 of FIG. 8) is relatively longer than another side edge (e.g., the second open end 353 of FIG. 8) at an arbitrary point of the flexible portion 350.

An electronic device 101, 200 according to an embodiment of the disclosure may include a housing 271 on which the printed circuit board 320, the metal sheet 370, and the metal member 305 are to be mounted, wherein the printed circuit board 320 may be mounted on the housing 271 such that the flexible portion in the printed circuit board 320 is positioned at a curved portion of the housing 271.

In an electronic device 101, 200 according to an embodiment of the disclosure, the washer 361 may include protrusions 363 of a protruding pattern engraved on the surface.

In an electronic device 101, 200 according to an embodiment of the disclosure, the predetermined angle θ1 may be 10° to 20°.

An antenna feeding structure 300 according to an embodiment of the disclosure may include a metal member 305, a metal sheet 370 disposed such that one surface (e.g., the first surface 371 of FIG. 9) faces the metal member 305, and a screw 380 provided to penetrate and fasten through the metal sheet 370 and the metal member 305 sequentially. The one surface of the metal sheet 370 may have an inclination at a predetermined angle θ1 relative to another surface (e.g., the second surface 373 of FIG. 9) facing a printed circuit board 320.

An antenna feeding structure 300 according to an embodiment of the disclosure may include a metal washer 361 disposed between the printed circuit board 320 and the metal sheet 370, and the washer 361 may have protrusions 363 of a protruding pattern engraved on the surface.

In an antenna feeding structure 300 according to an embodiment of the disclosure, the metal sheet 370 may be fused to a casing member 303.

In an antenna feeding structure 300 according to an embodiment of the disclosure, the printed circuit board 310 may be a rigid flexible printed circuit board (RF PCB) having rigid portions 320, 330 provided on at least one side of a flexible portion 350, and the printed circuit board 320 may have a tilt structure bent at a predetermined angle α in a width direction as one side edge 351 is relatively longer than another side edge 353 at an arbitrary point of the flexible portion 350.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order).It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101).For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device 101, 200, comprising:
frame 271;
a metal member 305 provided inside the frame 271;
a metal sheet 370 having a first surface 373 facing a printed circuit board 320 and a second surface 371 opposite to the first surface 373 facing the metal member 305; and
a screw 380 configured to sequentially penetrate the printed circuit board 320, the metal sheet 370 and the metal member 305;
wherein the metal sheet 370 includes:
the first surface 373 at an inclination with respect to the second surface 371 by a specified angle θ₁.

2. The electronic device of claim 1, further comprising a washer 361, the washer 361 disposed between the printed circuit board 320 and the metal sheet 370.

3. The electronic device of claim 1, wherein the printed circuit board 320 is tilted at the specified angle θ1 and disposed substantially parallel to the first surface 373.

4. The electronic device of claim 1, wherein the metal sheet 370 is fused to a casing member 303.

5. The electronic device of claim 4, wherein the casing member 303 includes a front case 272.

6. The electronic device of claim 1, wherein a third surface of the printed circuit board 320 facing the first surface 373 is a conductive surface, and a fourth surface opposite to the third surface is a non-conductive surface.

7. The electronic device of claim 6, wherein the printed circuit board 320 further comprises electrical wiring configured to supply power to the screw 380 on the fourth surface.

8. The electronic device of claim 1, wherein the screw 380 is fastened to the printed circuit board 320, the metal sheet 370, and the metal member 305 by side screw fastening.

9. The electronic device of claim 2, wherein the screw 380 is fastened to the washer 361 and the metal sheet 370 so that power can be supplied to the washer 361 and the metal sheet 370.

10. The electronic device of claim 1, wherein the printed circuit board 310 is a rigid/flexible printed circuit board (R-FPCB) in which rigid portion 320 and 330 is provided on at least one side of a flexible portion 350.

11. The electronic device of claim 10, wherein the screw 380 is fastened through the rigid portion 320 and 330.

12. The electronic device of claim 10 or 11, wherein the printed circuit board 320 has a tilt structure in which one side 351 is relatively longer than an other side 353 at an arbitrary point of the flexible portion 350 and is bent at a specified angle α in a width direction.

13. The electronic device of claim 12, further comprising a housing 271 on which the printed circuit board 320, the metal sheet 370, and the metal member 305 are mounted, and
wherein the printed circuit board 320 is mounted on the housing 271 such that the flexible portion 350 of the printed circuit board 320 is positioned on a curved portion of the housing 271.

14. The electronic device of any one of claims 1 to 13, wherein the specified angle θ₁ is 10 ° to 20 °

15. An antenna feeding structure 300 comprising:
a metal member 305;
a metal sheet 370 having one surface 371 facing the metal member 305; and
a screw 380 configured to sequentially penetrate the metal sheet 370 and the metal member 305;
wherein the metal sheet 370 includes:
the one surface 371 at an inclination with respect to the other surface 373 facing a printed circuit board 320 by a specified angle θ1.
